# EUROPEAN PATENT APPLICATION

(11) **EP 0 588 491 A2**
(43) Date of publication of application: **23.03.1994**
(21) Application number: 93306398.4
(22) Date of filing: 13.08.1993
(51) Int. Cl.: H01L 23/495

(54) **Lead frame for integrated circuits and a method for optimizing heat dissipation**

(30) Priority: 14.08.1992 US 929868
(71) Applicant: TEXAS INSTRUMENTS INCORPORATED, Dallas Texas 75265 (US)
(72) Inventor: Karr, Richard J., Rowlett, TX 75088 (US)
(74) Representative: Nettleton, John Victor

(57) **Abstract**

A lead frame (10) is connected to an integrated circuit (28) by adhesives or other epoxy compounds. The lead frame (10) includes one or more elongated conductive leads (22) and (24) to provide a flow path for thermal energy or heat generated by the integrated circuit (28). The lead frame (10) includes a die pad (12) for mounting all integrated circuit (28) thereon and one or more elongated conductive leads (20) for electrical connection to integrated circuit (28).

## Description

### TECHNICAL FIELD OF THE INVENTION

This invention relates to integrated and more particularly relates to a lead frame having one or more leads which dissipate heat produced during operation of an integrated circuit.

### BACKGROUND OF THE INVENTION

Various techniques have previously been used to package integrated circuits using lead frames and transfer molding equipment and procedures. Various lead frame designs are used with integrated circuits such as the flip chip design, the small outline J lead (SOJ) and the lead-on-chip (LOC). These techniques frequently include attaching an integrated circuit to a die mount pad or bar mount pad associated with the lead frame and connecting wire bonds between the integrated circuit and electrically conductive leads on the lead frame. The integrated circuit and lead frame are then placed in a mold and resin or thermal plastic molding compound injected into mold cavity. The integrated circuit and portions of the conductive leads are encapsulated by resin or molding compound. The encapsulated package is cured, deflashed and external portions of the conductive leads prepared (trim, formed, coated, etc.) as required for the specific integrated circuit design. The finished product is an integrated electrical circuit which has been encapsulated in a plastic body with electrically conductive leads extending from the plastic body.

While prior lead frames have worked satisfactorily in packaging many integrated circuits, the advent of more complex and smaller scale integrated circuits has increased the importance of dissipating heat produced by operation of the integrated circuit. As integrated circuits become more complex, additional electrically conductive leads are required to send and receive more signals from the integrated circuit. The increased number of signals frequently generates increased heat, particularly for high power circuits used in the interface between a microprocessor and peripheral equipment such as printers, modems, etc. Failure to satisfactory dissipate heat produced during operation of an integrated circuit can result in mechanical failure and physical damage to important electrical components within the integrated circuit.

A need has arisen for a lead frame which will satisfactorily dissipate heat produced during the operation of small scale, complex integrated circuits in high power operating environments such as those associated with a differential signal transmission device or high performance serial bus.

### SUMMARY OF THE INVENTION

In accordance with the present invention, disadvantages and problems associated with prior lead frames for integrated circuits that produce significant amounts of heat have been subsantially reduced or eliminated. An integrated circuit mounted on a lead frame is attached by electrically conductive connections to selected leads of the lead frame and thermally conductive connections with other selected leads. Both the electrically conductive only leads and the thermally conductive leads extend from the finished encapsulated package. The thermally conductive leads may also be electrically conductive if desired for the specific integrated circuit design associated with the lead frame.

In accordance with one aspect of the invention, an integrated circuit is attached to the die pad of a lead frame with one or more thermally conductive leads extending from the die pad and one or more electrically conductive leads attached to the integrated circuit.

The present invention has significant technical advantages in that a lead frame and its conductive leads may be designed to optimize both heat dissipation characteristics of the integrated circuit encapsulated with the lead frame and electrical signal carrying characteristics associated with the integrated circuit. The present invention allows an integrated circuit designer to optimize the number of leads carrying electrical signals and the quantity of heat which can be dissipated by the encapsulated integrated circuit package.

The present invention has another significant technical advantage in that the die pad of the lead frame functions as a receptacle or heat sink to receive heat generated by the integrated circuit during normal operation and to transfer the heat to a bus bar in the equipment associated with the encapsulated integrated circuit package.

An important technical advantage of the present invention is the ability to significantly increase the number of electrical signals processed by and the power rating of very complex integrated circuits packaged in a small space and at the same time avoid heat problems associated with the increased number of signals and increased power. This invention is particularly useful in application such as notebook size personal computer and half-height hard disk drives.

The present invention has an additional significant technical advantage in that the lead frame allows multiple channel signal devices which meet differential transmission standards associated with small computer system interface requirements and integrated peripheral interface requirements. The heat dissipation capabilities resulting from the present invention allow complex integrated circuits to be placed in a very small encapsulated package such as the shrunk small outline package (SSOP). The present invention allows designers and manufacturers of equipment such as hard disc drives to include the capabilities of a complex multiple channel signal processing integrated circuit into a very small space without experiencing problems due to the heat generated by operating high power circuits in small encapsulated packages.

### BRIEF DESCRIPTION OF THE DRAWINGS

For a more complete understanding of the present invention and the advantages thereof, reference is now made to the following description taken in conjunction with the accompanying drawings in which:
FIGURE 1 is a plan view with portions broken away of a lead frame and integrated circuit incorporating the present invention;
FIGURE 2 is an isometric drawing showing the lead frame and integrated circuit of FIGURE 1 following encapsulation; and
FIGURE 3 is a schematic drawing of three encapsulated integrated circuits incorporating the present invention inserted into a bus bar.

### DETAILED DESCRITION OF THE INVENTION

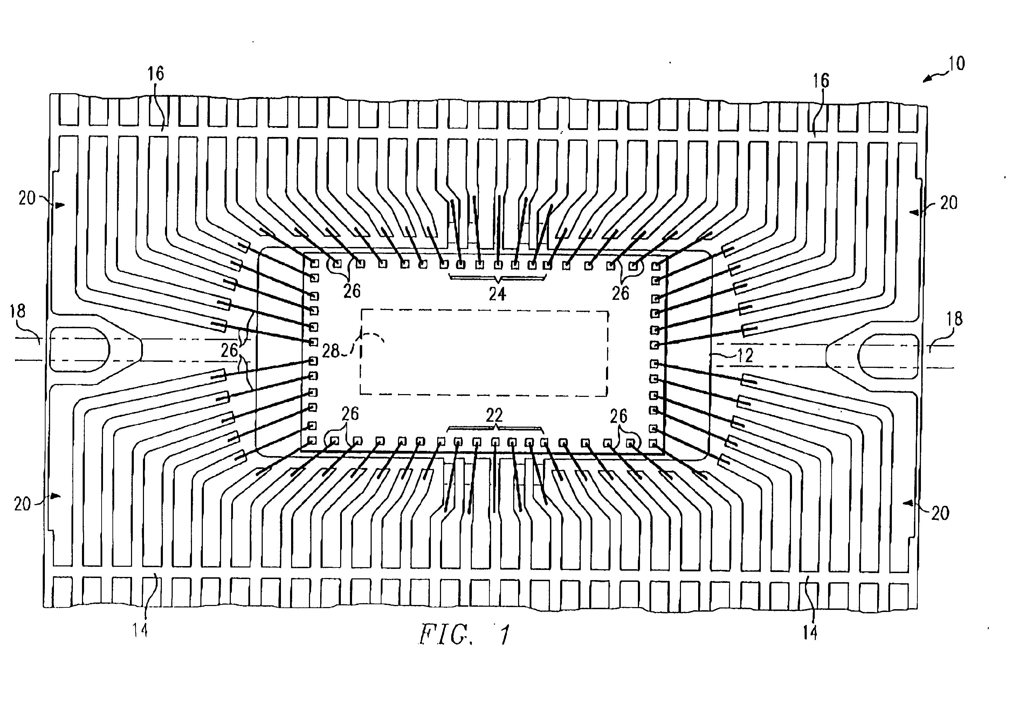

Referring to FIGURE 1, lead frame 10 of the present invention comprises a metal sheet which may be formed from various metal alloys, such as full hard temper CDA alloy 151 having an approximate thickness of .008" and may be spotted plated with gold, silver or other metals. Lead frame 10 has a plurality of cut-outs stamped therein to partially define the electrically conductive lead configuration for the desired integrated circuit Specifically, lead frame 10 comprises die pad 12 with a plurality of elongated, conductive leads 20 adjacent thereto. Die pad 12 may sometimes also be referred to as a die mount pad or bar pad. Elongated conductive leads 20 are positioned in a generally parallel relationship with respect to adjacent conductive leads. For lead frame 10 of FIGURE 1 a total of fifty-six conductive leads 20 are provided. As will be explained later in more detail, conductive leads 20 may be used to transmit electrical signals to and from an integrated circuit mounted on die pad 12 and/or may be used to dissipate thermal energy from die pad 12.

Different numbers of conductive leads 20 may be provided by lead frame 10 as required for the design of the specific integrated circuit which will be mounted on or attached to die pad 12. Support bars 14 and 16 are used to position conductive leads 20 relative to die pad 12. Following encapsulation of integrated circuit 28 mounted on die pad 12 and connected to conductive leads 20, support bars 14 and 16 are cut away or trimmed along with portions of conductive leads 20 during the final assembly of the encapsulated package into finished component 32. Lead frame 10 generally includes a pair of die pad supporting arms 18 which provide mechanical support for die pad 12 during the process of mounting integrated circuit 28 thereon. Die pad support arms 18 are trimmed or removed from die pad 12 during the assembly process.

As integrated circuits become smaller and more complex, an increasing number of electrical signals must be supplied to an integrated circuit to take full advantage of the circuits' design capabilities. Increasing the number of electrical signals supplied to integrated circuit 28 requires a corresponding increase in the number of conductive leads 20 provided by lead frame 10. As best shown in FIGURE 1, in order to increase the number of conductive leads 20, the spacing between adjacent conductive leads 20 must be significantly reduced near die pad 12. The present invention is particularly useful for lead frames which have a center line spacing of less than thirty thousandths of an inch (30 mils) between the tip of adjacent conductive leads 20 near integrated circuit 28 and die pad 12. This substantial reduction in the spacing between conductive leads 20 is required to provide the number of conductive leads to take full advantage of the operational capabilities of integrated circuit 28. By processing a large number of electrical signals with a single integrated circuit 28, less board space is required in the final application for finished component 32. For example, if integrated circuit 28 can process a total of 40 separate electrical signals, one finished component 32 can take the place of two integrated circuits which process only twenty separate signals. For this example, using integrated circuit 28 and lead frame 10 would reduce space requirements in the final application (bus bar40) by fifty percent (50%) and still allow processing the same total number of electrical signals.

Various procedures and techniques are well-known to mount or attach integrated circuit 28 to die pad 12 in preparation for encapsulation of integrated circuit 28, die pad 12 and portions of conductive leads 20. Various types of double sided adhesives are well known in the art of manufacturing encapsulated integrated circuits for use in attaching integrated circuit 28 to die pad 12. An example of one such adhesive is double sided thermal setting epoxy adhesive coated polyamide film. This adhesive is a good conductor of any thermal energy produced during operation of integrated circuit 28 and allows heat to transfer easily to die pad 12.

Novolac epoxy compound has been found to be a satisfactory resin for use during encapsulation of integrated circuits. This compound provides both the required physical holding characteristics needed to mechanically bond integrated circuit 28 and die pad 12 and also has good electrical insulation characteristics. Various wire bonding techniques arc well-known to electrically connect selected conductive leads 20 with various components of integrated circuit 28 attached to die pad 12. These electrical connections are shown by wire bonds 26 of FIGURE 1.

During the manufacture of lead frame 10, the ends of selected conductive leads 20 adjacent to die pad 12 may be removed by etching or other suitable process to provide a gap or space there between. An important element of the present invention is that another selected group of conductive leads 20 designated as leads 22 and 24 remain physically attached to and directly connected with die pad 12. For the specific configuration shown in FIGURE 1, five conductive leads 20 are included in group 22 and five conductive leads 20 are included in group 24. Due to the direct, physical connections between conductive leads 22 and conductive leads 24 with die pad 12, any heat transferred to die pad 12 by integrated circuit 28 during operation of the integrated circuit will in turn be dissipated by orflow through conductive leads 22 and 24. Die pad 12 and conductive leads 20 are manufactured from the same original raw material. Therefore, die pad 12 and the conductive leads in groups 22 and 24 have approximately the same thermal transfer characteristics.

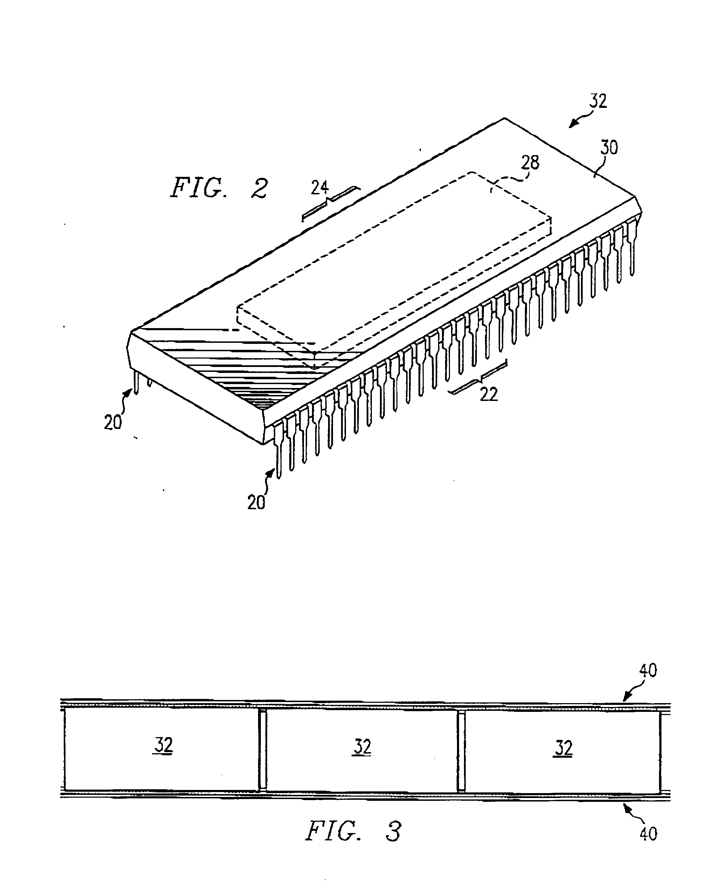

As best shown in FIGURE 2, integrated circuit 28 and portions of lead frame 10 have been encapsulated in plastic body 30 to produce an electronic device or finished component 32 which may be used in the manufacture and assembly of various types of electronic equipment. Portions of conductive leads 20 extend from plastic body 32 for attachment with bus bar 40 or similar connection to equipment which will use integrated circuit 28. Due to the thermally conductive connection between integrated circuit 28 and die pad 12, heat produced by operation of integrated circuit 28 will flow via die pad 12 and groups 22 and 24 of conductive leads 20 to the exterior of plastic body 30. When component 32 is attached to bus bar 40 as shown in FIGURE 3, the heat dissipation characteristics of conductive lead groups 22 and 24 are further improved. FIGURE 3 shows three finished components 32 attached to bus bar 40.

Integrated circuit 28 is preferably a high capacity complex circuit capable of use in differential signal transmission systems. An example might be as a small computer silicone interface (SCSI). Such integrated circuits are used to process significant amounts of signal information. Therefore, a large number of leads such as the fifty-six potential leads shown on lead frame 10 are appropriate for use with these complex integrated circuits. One of the drawbacks to complex integrated circuit 28 used in high power applications is that the voltage and current flow associated with such integrated circuits will generate significant amounts of heat during normal operation. As the amount of power used by integrated circuit 28 increases, the requirement for heat dissipation also increases. If the heat is not adequately dissipated, various elements of integrated circuit 28 may be damaged.

An important feature of the present invention is that a circuit designer, after selecting a specific integrated circuit which will be mounted on die pad 12, may make a first calculation of the power that will be required to operate the integrated circuit and the number of leads 20 which will be required to be electrically connected to the integrated circuit. Frequently, as more conductive leads 20 are electrically attached to integrated circuit 28 to provide additional signals for processing by integrated circuit 28, the power used by integrated circuit 28 increases and heat produced increases. In many design applications there is a correlation between the number of elongated conductive leads 20 which are electrically attached to integrated circuit 28 and the heat dissipation requirements during operation of integrated circuit 28.

After calculating the amount of power that will be generated by the integrated circuit 28, the circuit designer may then calculate the number of thermally conductive leads 22 and 24 which are required to dissipate this amount of heat via die pad 12. The heat produced by integrated circuit 28 must be dissipated to maintain the temperature of integrated circuit 28 at an acceptable level. As the number of conductive leads 20 physically attached to die pad 12 increases, the amount of heat which can be transferred from die pad 12 also increases. Therefore, there is a correlation between heat dissipation and the number of conductive leads included within groups 22 and 24.

As an extreme example, if none of the conductive leads 20 remain directly attached to die pad 12, the heat dissipation characteristics are reduced to a very small amount and circuit 28 could be damaged during high power operations. As an example in the other extreme, if only two conductive leads 20 are used to supply electrical signals to circuit 28, the remaining conductive leads 20 could be physically attached directly to die pad 12 to provide maximum heat dissipation capabilities. The circuit designer can determine the optimum number of signals which need to be transmitted to and from integrated circuit 28 through conductive leads 20 and the number of conductive leads 20 which must be used for heat dissipation. The design flexibility offered by the present invention greatly expands the number of potential uses for integrated circuit 28 and lead frame 10. By using the present invention, it is no longer necessary to redesign or modify integrated circuit 28 or redesign or modify the basic configuration of lead frame 10. The designer only has to adjust and vary the number of elongated conductive leads 20 which remain attached directly to die pad 12.

The group of thermally conductive leads designated 22 and 24 may also be electrically connected by wire bonds 26 to integrated circuit 28. Since conductive leads designated 22 and 24 remain physically attached to die pad 12, they must carry the same electrical signal. For example, the group of leads designated as 22 and 24 could be used as grounding leads for integrated circuit 28 or any other electrical signal which has a constant voltage. The group of leads designated 22 and 24 might be used to provide a constant five volt power supply to integrated circuit 28. Thus, lead frame 10 of FIGURE 1 has fifty-six conductive leads 20 which could provide a total of fifty-six separate signals to integrated circuit 28 but very limited heat dissipation. By grouping or ganging five leads 20 in the group designated as 22 and five leads 20 in the group designated as 24, the total number of signals which can be transmitted to integrated circuit 28 by lead frame 10 is reduced from fifty-six to forty-seven.

The present invention has been described with respect to a lead frame with fifty-six potential leads for fifty-six potentially different signals. Those skilled in the art will readily note that the present invention could be used with a lead frame having a substantially larger number of leads. The present invention allows optimizing the choice between using leads to only conduct electrical signals to and from an integrated circuit and using leads physically connected to the lead frame die pad to dissipate heat generated by the integrated circuit. Those skilled in the art will also readily note that an integrated circuit having a leading frame incorporating the present invention can be used with various differential signal transmission devices.

Although the present invention has been described in detail, it should be understood that various changes, substitutions and alterations can be made therein without departing from the spirit and the scope of the invention as defined by the following claims.

## Claims

1. A lead frame for an integrated circuit comprising;
a plurality of conductive leads extending in side-by-side relationship;
a die pad for use in mounting the integrated circuit on the lead frame;
means for electrically attaching selected conductive leads with the integrated circuit; and
means for dissipating heat energy produced by the integrated electrical circuit during its operation.

2. The lead frame of Claim 1, wherein the means for dissipating heat energy further comprises a thermally conductive connection between at least one of the conductive leads and the die pad.

3. The lead frame of any preceding claim, wherein the plurality of conductive leads comprise:
a first selected group of conductive leads with only electrical connections to the integrated circuit; and
a second selected group of conductive leads with thermally conductive connections to the integrated circuit.

4. The lead frame of Claim 3, further comprising a plurality of wire bonds electrically connecting the integrated circuit with the first selected number of conductive leads and a plurality of wire bonds electrically connecting the second selected number of conductive leads with the integrated circuits.

5. The lead frame of claim 3, or claim 4, further comprising five conductive leads thermally connected to one side of the die pad and five conductive leads thermally connected with the opposite side of the die pad.

6. The lead frame of any of claims 3 to 5, further comprising the heat dissipating capability of the second group of conductive leads being greater than the heat produced by the integrated circuit from signals received through the first group of conductive leads.

7. The lead frame of any preceding claim wherin the distance between the center line of adjacent elongated conductive leads near the die pad is generally less than thirty thousandths of an inch (30 mils).

8. A method for dissipating heat produced by an integrated circuit attached to a lead frame with a plurality of elongated conductive leads for encapsulation within a plastic body comprising;
selecting a first number of elongated conductive leads which will be only electrically connected to the integrated circuit;
calculating the heat which will be produced by the integrated circuit when the first number of electrically conductive leads are in operation;
determining a second number of elongated conductive leads which must be thermally connected to a die pad to dissipate the heat generated by the integrated circuit with the first number of electrically connected leads;
mounting the integrated circuit to a die pad on the lead frame with a thermally conductive connection;
connecting the first number of elongated conductive leads with only an electrical connection to the integrated circuit; and
providing a thermal connection between the second number of elongated conductive leads and the die pad.

9. The method of claim 8, further comprising the step of optimizing the number of elongated conductive leads used to transmit electrical signals to and from the integrated circuit and the number of elongated conductive leads used to dissipate heat from the die pad.

10. The method of claim 8 or claim 9, furthercompris- ing the steps of:
forming the die pad and elongated conductive leads from a single sheet of raw material with all of the elongated conductive leads physically attached to and extending from the die pad;
forming a gap between one end of a first number of elongated conductive leads and the die pad; and
maintaining the physical connection between the die pad and a second number of elongated conductive leads.

11. The method of claim 10 further comprising the step of forming an electrical connection between the circuit and selected elongated conductive leads.

12. The method of any of claims 8 to 11, further comprising the step of forming the elongated conductive leads with a spacing of less than thirty thousandths of an inch between the center line of adjacent conductive leads near the integrated cir- cu it.
